(19) Europäisches Patentamt
European Patent Office
Office européen des brevets

(11) Publication number: **0 413 475 A2**

# (12) EUROPEAN PATENT APPLICATION

(21) Application number: **90308505.8**

(51) Int. Cl.$^5$: **H03D 1/22**

(22) Date of filing: **02.08.90**

(30) Priority: **14.08.89 US 393496**

(43) Date of publication of application:
**20.02.91 Bulletin 91/08**

(84) Designated Contracting States:
**DE FR GB IT**

(71) Applicant: **DELCO ELECTRONICS CORPORATION**
**700 East Firmin Street**
**Kokomo Indiana 46902(US)**

(72) Inventor: **Kennedy, Richard Albert**
**R.R. No. 3, Box 33**
**Russiaville, Indiana 46972(US)**
Inventor: **Manlove, Gregory Jon**
**1403 Honey Lane**
**Kokomo, Indiana 46902(US)**
Inventor: **Marrah, Jeffrey Joseph**
**235 North County Road 820 West**
**Kokomo, Indiana 46901(US)**

(74) Representative: **Denton, Michael John et al**
**Patent Section Vauxhall Motors Limited 1st Floor Gideon House 26 Chapel Street**
**Luton Bedfordshire LU1 2SE(GB)**

## (54) Analogue/digital phase locked loop.

(57) A phase locked loop (PLL) with a narrow bandwidth, and small phase noise which is particularly useful in a FM stereo decoder includes both analogue and digital circuitry and has the advantages of both types of systems, performing better than standard PLL's without the need for any external components. An externally referenced digital voltage controlled oscillator (26), establishes the centre frequency of the PLL while analogue portions (28) of the circuit permits accurate locking to the input signal and provides a high level of quietness of the system.

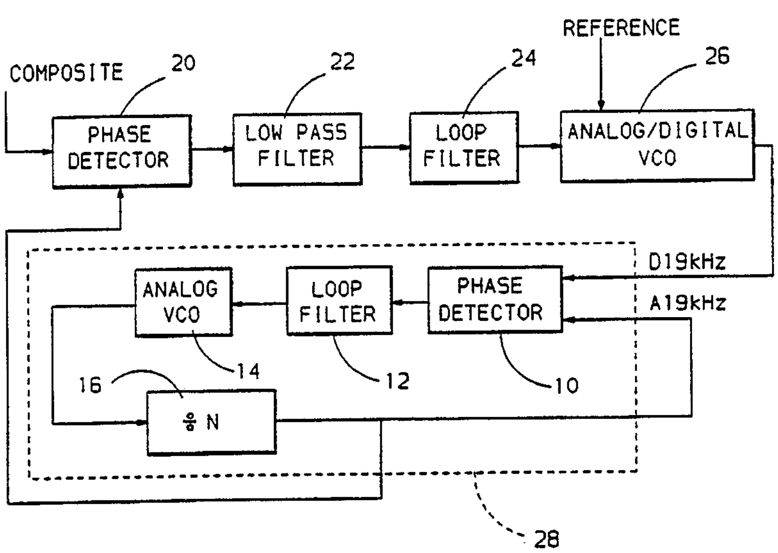


FIG.2

EP 0 413 475 A2

# ANALOGUE/DIGITAL PHASE LOCKED LOOP

This invention relates to phase-locked loops (PLL) and more particularly to a PLL for a FM stereo decoder which includes an analogue PLL incorporated in the feedback of a digital PLL.

All FM stereo receivers must perform three functions. First, the decoder must detect and lock onto the 19kHz pilot signal that is added to the FM composite for synchronization of the transmitter and receiver. This synchronization is accomplished with a PLL. Once locked, the decoder is in sync with the transmitted signal and the second function is performed, namely to multiply the FM composite signal by a 38kHz signal that is in phase with the original 19kHz pilot signal. This multiplication process brings the "Left - Right" signal down to the base band (0-15kHz) making it possible to separate the "Left + Right" and the "Left - Right" information with simple low-pass filters. Thirdly, these signals are summed and differenced to give the desired "Left" and "Right" information reproduced at the speakers of a FM stereo receiver.

The accuracy and noise characteristics of the PLL are very important. Any noise on the 38kHz signal generated in the PLL will appear in the "Left - Right" signal path. The noise in the signal path is an important measure of the decoder performance and must be minimized. Any inaccuracies in the PLL will cause the gain of the two signal paths to be mismatched. Gain mismatch will cause some "Left(Right)" channel information to be present on the "Right(Left)" output. The parameter called "separation" is a measure of how well the decoder separates the "Left" and "Right" signals and is therefore a benchmark for decoder performance.

A standard PLL is shown in Figure 1. It is comprised of a first phase detector 10, a loop filter 12 (first filter means), a voltage controlled oscillator (VCO) 14, and a frequency divider 16. In an analogue system, the first phase detector 10 generates a voltage proportional to the difference in the phase between the output of frequency divider 16 and the system input. This voltage is fed through the loop filter 12 and then to the input of the VCO 14. When the VCO output is in phase with the incoming signal, the output of the first phase detector 10 stops moving. If the frequency divider 16 is a divide by 2 and the PLL is locked to 19kHz, the VCO output is 38kHz, which is required in the decoder signal path.

Analogue PLL's have analoque VCO's which are inaccurate and are temperature dependent. Costly external components are required, and the bandwidth of the PLL must be widened to account for temperature variation, thereby reducing system performance. In a digital system, the operation of the circuitry is much the same except digital words are used instead of analogue voltages. One such digital PLL is disclosed in US patent no. 4,577,163. Digital PLL's have digital VCO's, the output frequency of which is controlled by an input bit pattern. The free running frequency of the PLL is very accurate, but the VCO output can only move in quantized steps of frequency. This frequency out is close to correct on the average, but at any one instant in time it may be incorrect. This quantization causes phase error which limits the performance of the FM stereo decoder.

A phase locked loop in accordance with the present invention comprises an analogue phase locked loop comprising a first phase detector, an analogue voltage controlled oscillator, first filter means responsive to the output of the first phase detector for providing an input to the analogue voltage controlled oscillator, and connecting means connecting the output of the analogue voltage controlled oscillator as a first input to the first phase detector; an analogue/digital voltage controlled oscillator; a second phase detector adapted to receive an FM composite input signal including a pilot signal; second filter means responsive to the output of the second phase detector for providing an analogue control input to the analogue/digital voltage controlled oscillator, the analogue/digital voltage controlled oscillator receiving a reference input frequency signal from a reference oscillator source and including means providing an output signal which on average is equal to the pilot signal; wherein the analogue phase lock loop is connected in the feedback path between the analogue/digital voltage controlled oscillator and the second phase detector for averaging the output of the analogue/digital voltage controlled oscillator, the first phase detector being adapted to receive the output of the analogue/digital voltage controlled oscillator, and wherein the connecting means also provides the first input to the second phase detector.

The PLL of the present invention is a combined digital and analoque circuit particularly useful in the decoder of a FM stereo receiver. The centre frequency of the PLL is established with an analogue/digital VCO referenced to an external squarewave generated with a crystal controlled oscillator. The analogue/digital VCO is described in detail in our patent application no (MJD/3347) and filed the same day as the present application. The digital portion of the PLL accurately sets the centre frequency. The analogue portion of the circuit affects how the circuit locks onto a signal, and the overall quietness of the system. The PLL of the present invention is thus both analoque and digital. It has the advantages of both types of systems, performing better than standard PLL's without the need for any external components.

Accordingly, it is an object of the present invention to provide a fully integrated phase-locked loop circuit with a narrow bandwidth, and small phase noise which is particularly useful in a FM stereo decoder.

The present invention will now be described, by way of example, with reference to the following description, taken in conjunction with the accompanying drawings, in which:-

Figure 1 is a block diagram of a conventional phase-locked loop;

Figure 2 is a block diagram of the present invention;

Figure 3 is the analogue stage of the combined analogue and digital VCO shown in Figure 2;

Figure 4 is a block diagram of the digital stage of the combined analogue and digital VCO shown in Figure 2;

Figure 5 is a more detailed logic diagram of the block diagram of Figure 4; and

Figures 6a-6c are waveforms useful in explaining the operation of the analogue and digital VCO shown in Figure 2.

The analogue/digital PLL of the present invention is shown in Figure 2. It is comprised of a second phase detector 20, a lowpass filter 22, a loop filter 24, an analogue/digital VCO 26, and an analogue PLL generally designated 28. A 3.6 MHz squarewave input is provided to the analogue/digital VCO 26 from a crystal controlled oscillator (not shown).

The analogue PLL 28 of Figure 2 is conventional and includes the elements of Figure 1 which are numbered accordingly. The second phase detector 20 senses the phase difference between the 19kHz feedback from the analogue PLL 28 and the 19kHz pilot signal in the FM composite. The remaining signals on the input are ignored because of the narrow bandwidth of the analogue/digital VCO 26. This bandwidth is narrow because the free running frequency of the analogue/digital VCO 26 is accurate to within 1.9Hz of the 19kHz pilot (0.01 %). The output of second phase detector 20 is fed through the lowpass filter 22 and loop filter 24 (second filter means) to the input of the analogue/digital VCO 26. The output of the analogue/digital VCO 26 is a signal designated D19kHz having the same frequency as the input pilot on the average; however, a slight phase error results at any instant in time due to the quantization error in the output frequency caused by the digital circuitry. The analogue PLL 28, acts as a smoothing filter on the D19kHz signal. It is an averaging circuit and only sees the desired 19kHz signal. The output of the analogue PLL 28 is then used to generate the 38kHz sinewave used in the signal path of the FM decoder. This signal will be exact in frequency due to the digital portion of the analogue/digital PLL, and it will have low phase noise due to the analogue portion of the PLL. The analogue PLL 28 may have a wide bandwidth without affecting the signal to noise ratio of the FM decoder because the input is D19kHz, not the composite signal. Therefore the analogue PLL 28 may be fully integrated, requiring no external components.

The signal D19kHz has a main component at 19kHz and smaller components at other frequencies, due to the phase noise of the digital circuitry. The analogue PLL 28, locks onto the 19kHz component of the D19kHz input and ignores the other components caused by phase noise. As a result, the output of the analogue VCO 14 is a low noise signal. This signal is reduced by the frequency divider 16 (connecting means) to generate the signal designated A19kHz, a 19kHz signal with low phase noise. This signal is the other input to the second phase detector 20 of the analogue/digital PLL as well as the input to the first phase detector 10 of the analogue PLL 28.

The analogue/digital VCO 26 is shown in detail in Figures 3 and 4 and is comprised of two basic sections. The first section is a voltage to pulse converter as shown in Figure 3. A control voltage (Vc) for the analogue/digital VCO 26 is applied to a conventional switched capacitor integrator generally designated 29. If Vc is greater in amplitude than a predetermined reference voltage Vref, the output of an operational amplifier 30 (VRAMP) integrates toward ground. Capacitor CA in conjunction with switches S1-S4 act as an equivalent resistor, which combines with capacitor CB and operational amplifier 30 to form an integrator. A voltage divider formed by resistors 31, 32, 33 establish reference inputs Vhigh to the negative input of comparator 34 and Vlow to the positive input of comparator 35. The outputs of comparators 34 and 35 designated ADD and DELETE respectively are applied as inputs to a NOR gate 36 the output of which is applied to switch S9 and through inverter 37 to switch S10 to control capacitor CC. A voltage +VR is applied to S9 through switch S11 or a voltage -VR is applied to S9 through switch S12 under the control of comparator 38 which responds to the VRAMP output of operational amplifier 30. The output of comparator 38 is connected directly to S11 and through inverter 40 to S12. When VRAMP goes below Vlow, the DELETE signal goes high and switches S10 on. When switch S10 conducts, the ramp is then reset by taking a fixed charge off the capacitor CB equal to CC times +VR. When the ramp resets, the DELETE signal goes low and the process continues with VRAMP integrating towards ground. This allows the output to be fully continuous in voltage; thereby allowing the output frequency to be exact on the average.

If Vc is lower in amplitude than Vref, the output of the operational amplifier 30 (VRAMP) integrates toward supply. When VRAMP goes above Vhigh, the ADD signal goes high and the switch S9 is turned on and the switch S10 is turned off. The ramp is then reset by taking a fixed charge off the capacitor CB equal to CC times -VR. When the ramp resets, the ADD signal goes low and the process continues with VRAMP integrating towards supply. The RC time constant of the switched capacitor integrator 29 and the difference in amplitude between Vc and Vref determine the average rate of DELETE or ADD pulses. The switched capacitor integrator 29 averages out small perturbations on the Vc line which makes the circuit less sensitive to noise. Unlike the conventional switched capacitor VCO, the switched capacitor integrator 29 merely controls the gain of the analogue/digital VCO, not the free running frequency. Gain is not as important a parameter in the operation of the PLL, and any small gain in inaccuracy in this circuit does not limit the PLL system performance.

Referring now to Figure 4, the second section of the analogue/digital VCO is a digital divider (divider means) generally designated 50 which produces (on average) a 19kHz output based on a 7.2MHz reference signal. This reference signal is a doubled version of a 3.6MHz clock crystal reference. The digital divider 50 comprises a jitter divider 52 which divides the 7.2MHz input by a factor of 3 or a factor of 4 under the control of frequency controller 54. The frequency controller 54 responds to the ADD and DELETE pulses of the circuit of Figure 3 and provides a CTRL signal for placing the jitter divider 52 in a divide by 3 or a divide by 4 mode. In the absence of ADD or DELETE pulses the frequency controller 54 provides for one divide by 3 followed by twenty four divide by 4 operations. This provides an output which is 1.824MHz on the average. Divider 56 divides this signal by 96 to generate the desired 19kHz output. Because the frequency of the crystal reference is accurate to within 0.01%, the 19kHz output is accurate to within 1.9Hz. The digital divider 50 normally runs with the ratio of divide by three's and divide by four's as indicated above. An ADD or DELETE pulse either adds an extra divide by 3 or deletes a standard divide by 3 operation. This results in an slight change in the output frequency from the divider 56.

The circuitry of Figure 4 is shown in greater detail in Figure 5 and will be further explained with reference to Figures 6a-6c. The jitter divider 52 comprises D-type flip flops 60 and 62 and Nand gates 64 and 66. Nand gate 66 is enabled by the CTRL signal going high, and places the jitter divider 52 in the divide by 3 mode. The output of the jitter divider 52 provides the clock for five D-Type flip flops 68-76 and a T-Type flip flop 78. The D-type flip flops 68-76 are interconnected by Nand gates 80-86 and inverter 88 to produce a 96kHz signal at the output of the T-type flip flop 78. The 96kHz signal alternately enables Nand gates 90 and 92 which provide inputs to Nand gate 94 which provides the CTRL output to the jitter divider 52. The ADD and DELETE pulses of Figure 3 are latched by flip flops 96 and 98 which are clocked from the 96kHz signal and produce signals ADD/L and DELETE/L as shown in Figures 6a-6c. When there are no ADD or DELETE pulses, as in Figure 6a, the Nand gate 92 is disabled. The Nand gate 90 is enable through inverter 100 during the time when the 96kHz signal is low, that is, when QB of T-type flip flop 78 is high. The third input to Nand gates 90 and 92 is from the D-type flip flop 68 and 76 through Nand gate 102 and inverter 104 and positions the rising edge of the CTRL pulses.

In Figure 6a, both ADD/L and DELETE/L are low. Under this circumstance the jitter divider 52 produces its normal 1.824MHz output, providing the 19KHz output from divider 56. It will be noted that a single CTRL pulse occurs each cycle of the 96K signal, or each 75 cycles of the 7.2MHz input. When CTRL is high a divide by 3 operation is performed during 3 of the 75 cycles. During the remaining 72 cycles the divider 52 operates as a divide by 4.

In Figure 6b ADD/L is high. This enables Nand gate 92 when the 96K signal is high and forces the output of Nand gate 94 high when the Q output of D-type flip flops 68 and 76 are high. This adds an extra divide by 3 operation, so that two divide by 3 operations occur during 75 cycles of the 7.2MHz input. This extra divide by three occurs in place of a divide by 4 operation and increases the output frequency to its highest possible value of 1.82508MHz, producing 19.0112kHz at the output of the divider 56.

In Figure 6c DELETE/L is high and disables the Nand gate 90. This deletes the normal divide by 3 operation as long as DELETE remains high and decreases the output frequency to its lowest possible value of 1.82292Mhz, producing 18.9888kHz at the output of divider 56.

The ADD and DELETE pulses are in general never continuously high. Instead they are pulsed high to make small changes in the output frequency of the VCO. The average number of ADD or DELETE pulses, per unit time, affect the output frequency and are directly dependent on the input voltage Vc. The integrator time constant determines the gain of the system and a relatively large inaccuracy in the gain of the system has only a small effect on the performance of the PLL.

This circuit provides an accurate centre frequency without the use of external components, and the phase error is minimized by having a large input to output clock ratio and fixed charge reset.

The PLL of the present invention minimizes phase error, and yields high performance realizing the accuracy of a digital PLL without the associated phase noise.

Attention is drawn to our other patent application nos. (MJD/3346) and (MJD/3348), filed the same day as the present application.

## Claims

1. A phase locked loop comprising an analogue phase locked loop (28) comprising a first phase detector (10), an analogue voltage controlled oscillator (14), first filter means (12) responsive to the output of the first phase detector for providing an input to the analogue voltage controlled oscillator, and connecting means (16) connecting the output of the analogue voltage controlled oscillator as a first input to the first phase detector;
characterised by an analogue/digital voltage controlled oscillator (26); a second phase detector (20) adapted to receive an FM composite input signal including a pilot signal; second filter means (22,24) responsive to the output of the second phase detector for providing an analogue control input to the analogue/digital voltage controlled oscillator, the analogue/digital voltage controlled oscillator receiving a reference input frequency signal from a reference oscillator source and including means (50) providing an output signal which on average is equal to the pilot signal; and in that the analogue phase lock loop is connected in the feedback path between the analogue/digital voltage controlled oscillator and the second phase detector for averaging the output of the analogue/digital voltage controlled oscillator, the first phase detector being adapted to receive the output of the analogue/digital voltage controlled oscillator, and the connecting means also providing the first input to the second phase detector.
2. A phase locked loop as claimed in claim 1, wherein the analogue/digital voltage controlled oscillator (26) has a centre frequency equal to the frequency of the pilot signal and is referenced to the output of a crystal oscillator.
3. A phase locked loop as claimed in claim 1 or claim 2, wherein the pilot signal is a 19kHz pilot signal of the FM composite input signal.
4. A phase locked loop as claimed in any one of claims 1 to 3, wherein the means providing an output signal which on average is equal to the pilot signal includes divider means (50).
5. A phase locked loop as claimed in claim 4, wherein the divider means comprises a jitter divider (52) connected with the reference oscillator source for providing the reference input frequency signal at a predetermined frequency, and wherein the analogue/digital voltage controlled oscillator (26) further includes frequency control means (54) for controlling the jitter divider in response to the analogue control input.

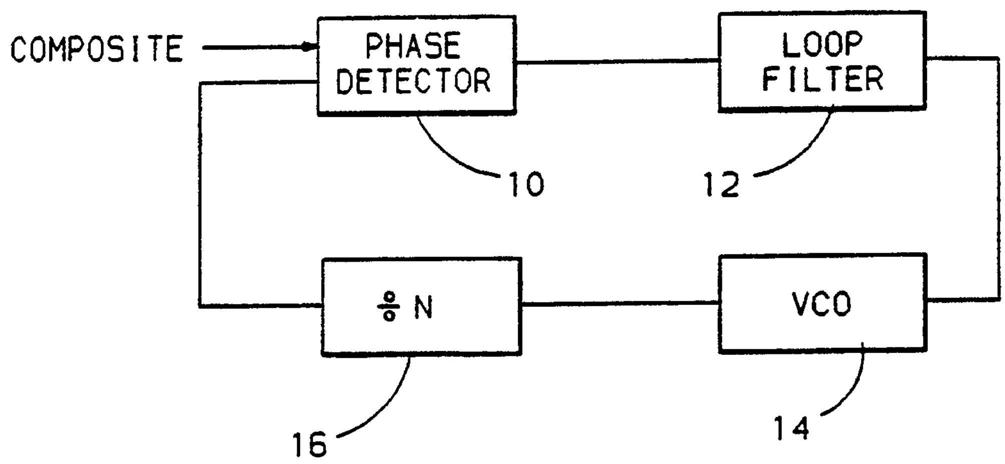
COMPOSITE
PHASE DETECTOR
LOOP FILTER
÷ N
VCO
10
12
16
14

FIG. 1

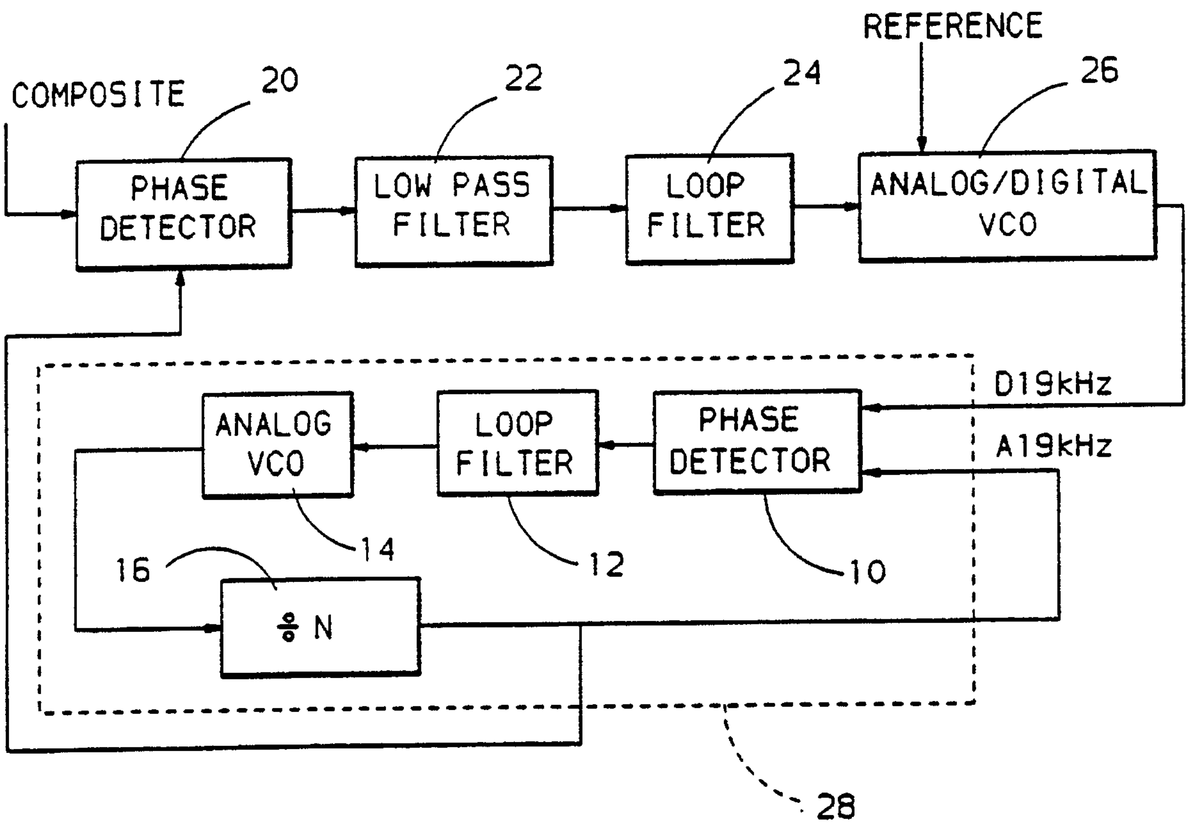
REFERENCE
COMPOSITE
20
22
24
26
PHASE DETECTOR
LOW PASS FILTER
LOOP FILTER
ANALOG/DIGITAL VCO
D19kHz
A19kHz
ANALOG VCO
LOOP FILTER
PHASE DETECTOR
16
14
12
10
÷ N
28

FIG. 2

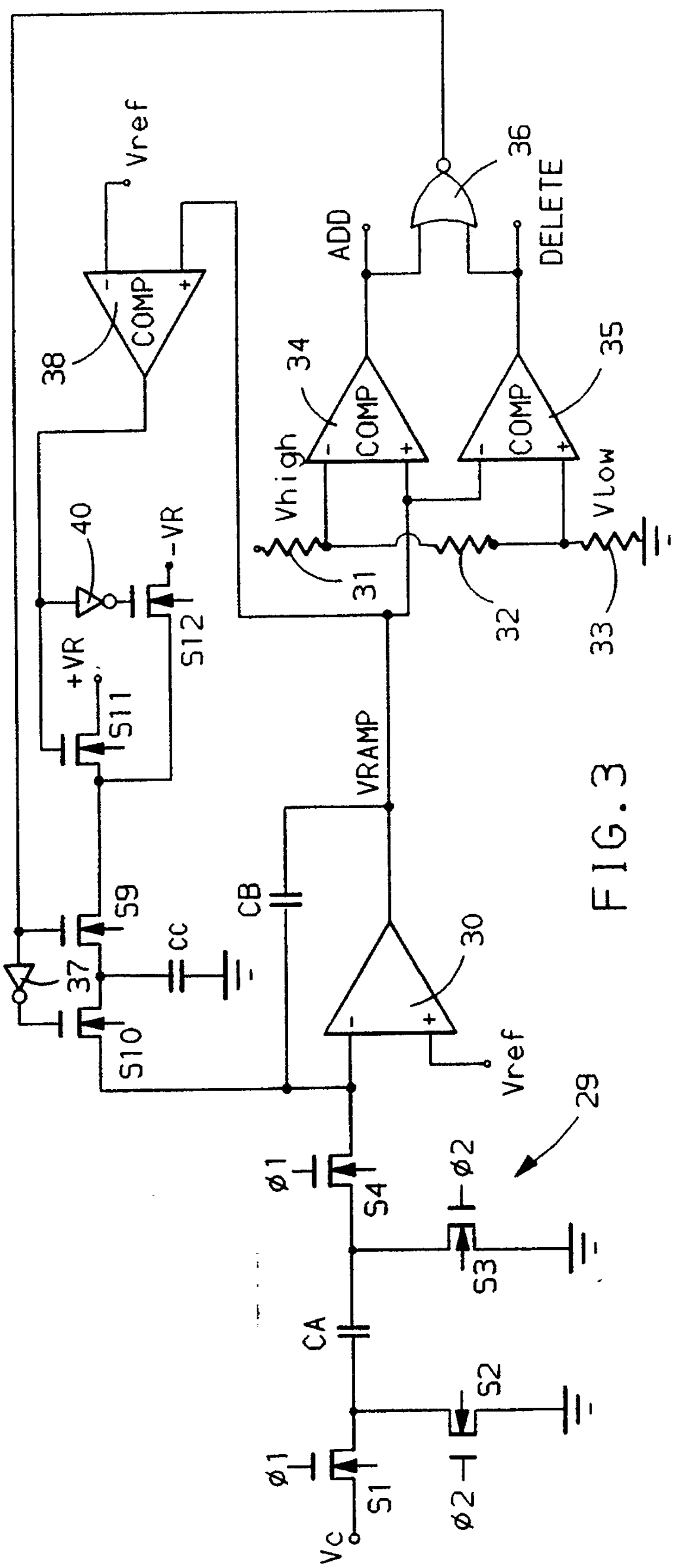
Vref
COMP
38
ADD
DELETE
36
34
35
COMP
COMP
Vhigh
Vlow
40
-VR
+VR
S11
S12
31
32
33
VRAMP
S9
37
CC
CB
S10
30
Vref
29
Ø1
S4
Ø2
S3
CA
S2
Ø1
S1
Ø2
Vc

FIG. 3

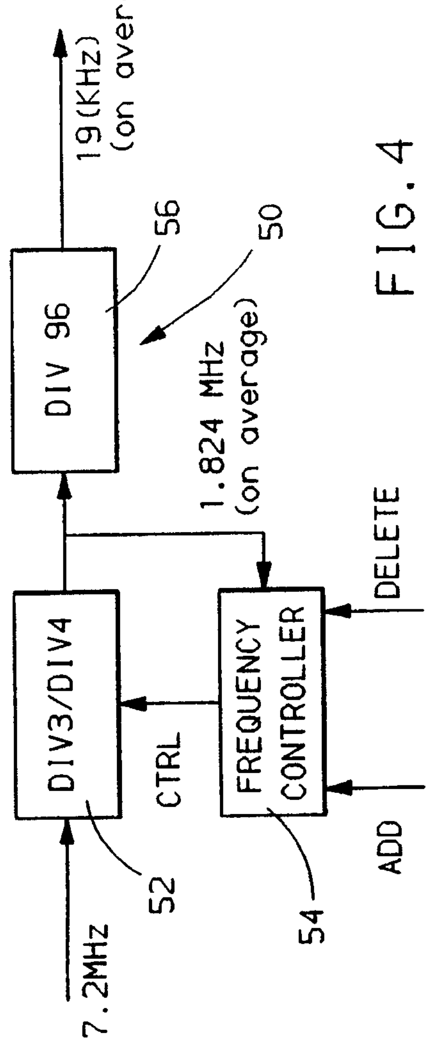
19(KHz)
(on average)
56
50
DIV 96
1.824 MHz
(on average)
DELETE
DIV3/DIV4
FREQUENCY
CONTROLLER
CTRL
ADD
7.2MHz
52
54

FIG. 4

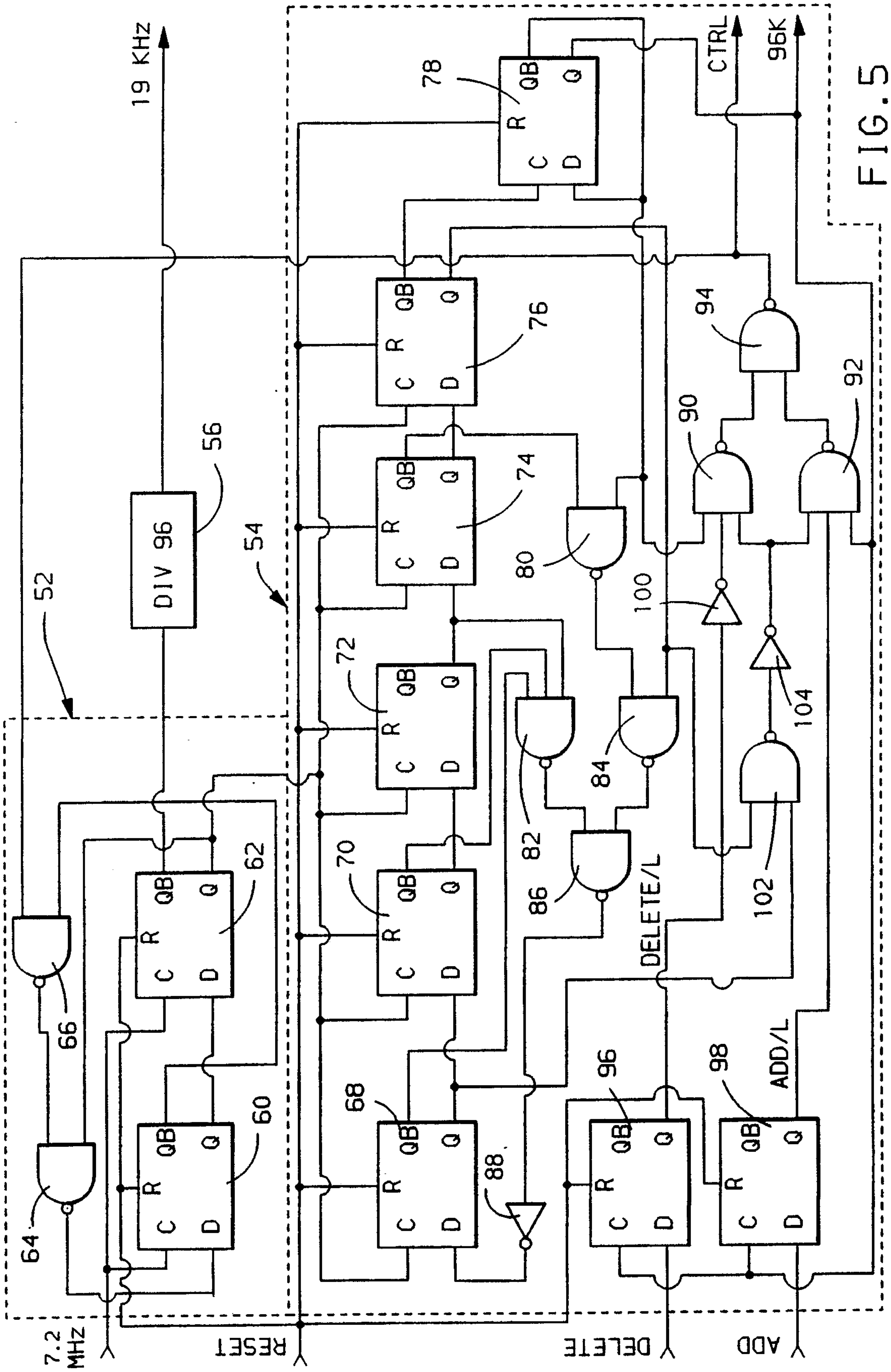
19 KHz
DIV 96
CTRL
96K
7.2 MHz
RESET
DELETE
ADD
DELETE/L
ADD/L
52
54
56
60
62
64
66
68
70
72
74
76
78
80
82
84
86
88
90
92
94
96
98
100
102
104

FIG. 5

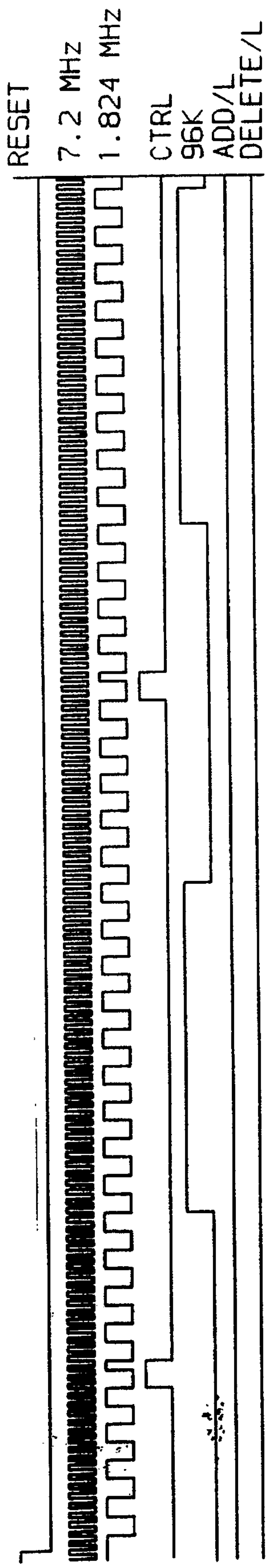


FIG.6a

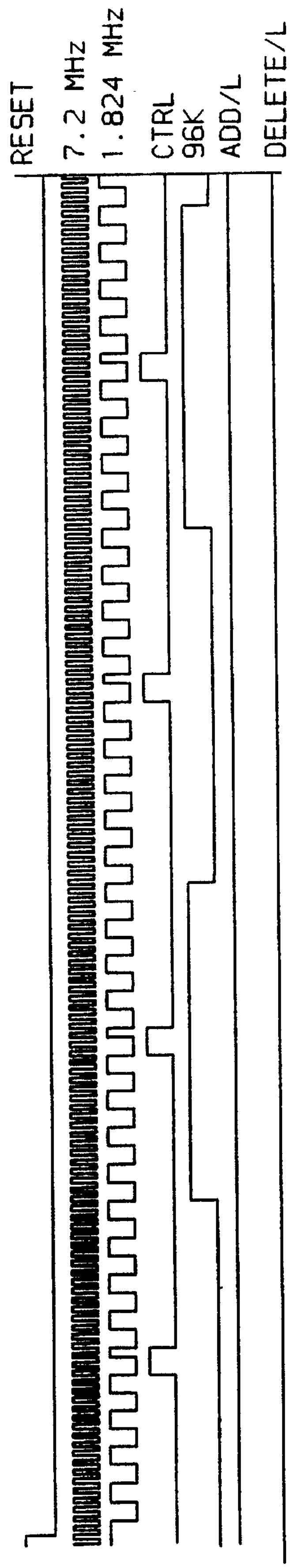


FIG.6b

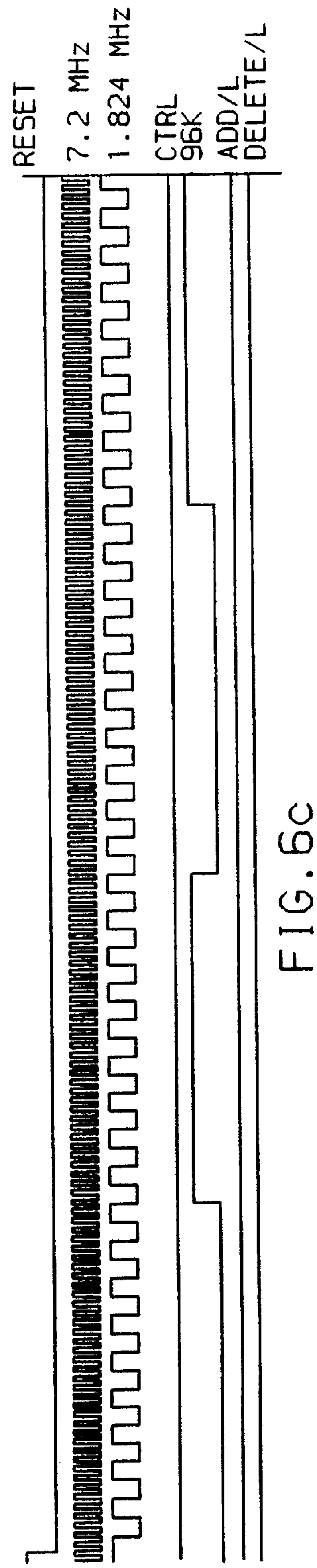


FIG.6c